# EUROPEAN PATENT SPECIFICATION

(11) **EP 0 274 278 B1**
(45) Date of publication and mention of the grant of the patent: **25.05.1994**
(21) Application number: 87311541.4
(22) Date of filing: 31.12.1987
(51) Int. Cl.: H01L 29/10, H01L 29/784

(54) **MOS field effect transistor and method of manufacturing the same**
MOS-Feldeffekttransistor und dessen Herstellungsmethode
Transistor à effet de champ MOS et procédé pour sa fabrication

(30) Priority: 05.01.1987 JP 321/87; 16.01.1987 JP 7553/87; 21.01.1987 JP 11861/87; 19.02.1987 JP 36618/87; 21.04.1987 JP 97960/87; 15.05.1987 JP 119543/87
(43) Date of publication of application: 13.07.1988
(73) Proprietor: SEIKO INSTRUMENTS INC., Tokyo 136 (JP)
(72) Inventor: Aoki, Kenji, Koto-ku Tokyo (JP); Takada, Ryoji, Koto-ku Tokyo (JP)
(74) Representative: Sturt, Clifford Mark

(56) References cited:
- EP-A- 0 051 504
- EP-A- 0 203 516
- US-A- 4 242 691
- IBM TECHNICAL DISCLOSURE BULLETIN, vol. 20, no. 10, March 1978, pages 4178-4180; E.F. MIERSCH et al.: "FET structures for very high performance circuits operating at low temperatures"
- S.M. Sze "Physics of Semiconductor Devices, Second Edition" (J. Wiley & Sons, New York, 1981), pages 362-373.
- J. Electrochem. Soc., vol. 137, no. 6, June 1990, pages 1898-1904.

## Description

This invention relates to a MOS field effect transistors (hereinafter referred to as MOSFETs) and to methods of manufacturing the same. MOSFETs operating with low power consumption and at a high speed are used as memory devices and switching devices in computers. A typical example of such MOS field effect transistors can be found in U.S. Patent No. 4,242,691 by Mitsubishi.

Miniaturisation of a MOSFET poses difficult problems, in particular for example, problems associated with a short channel effect. This effect is characterised by a lowered threshold voltage. For a given channel doping concentration, as the channel length is reduced, a depletion layer extending towards a gate region becomes to serve as a depletion layer additional to the depletion layer at a drain electrode and subsequently reduces the depletion layer at the gate region. This eventually lowers the threshold voltage. In addition to this effect, there is a problem in CMOS structure, namely, latch-up which is a parasitic bipolar action. One approach to avoid this latch-up is to increase impurity concentration of the substrate thereby reducing the resistance of the substrate. However, if the impurity concentration is increased to such an extent as to prevent latch-up, the threshold voltage increases to an undesirable level. Also, if impurity concentration in the channel region where carriers traverse, is high, the effect of scattering by impurity atoms increases, generally resulting in lowered carrier mobility.

Consequently an aim of the present invention is to allow a high impurity concentration in the subtrate to avoid the problems of the short channel effect and latch-up but control the threshold voltage.

According to the present invention there is provided a MOS field effect transistor comprising:
a semiconductor substrate having an impurity concentration of at least 3 x 10¹⁶ cm⁻³ and a relatively short channel region disposed therein; characterised by
an epitaxial growth layer provided in said channel region, having an impurity concentration lower than that of said substrate and a thickness of 50nm (500 Å) or less.

In one embodiment said epitaxial growth layer comprises at least two epitaxial growth layers of different impurity doping concentration and thickness.

Also according to the present invention there is provided a method of manufacturing such a MOS field effect transistor characterised by comprising: forming on a substrate a source region and a drain region by using ion implantation, and thereafter selectively depositing an epitaxial growth layer at a substrate temperature of 850°C or less between said source and drain regions to form a channel region.

The method may include forming the substrate with a partially concave area such that said epitaxial growth layer is selectively deposited on a portion of the substrate surface lower than other areas of the substrate surface. The method may further include finally forming a thermal oxide film on the substrate surface forming a polysilicon film thereover and thereafter etching said polysilicon film except over said channel region.

Also according to the present invention there is provided a method of manufacturing such a MOS field effect transistor comprising:
forming on a substrate using molecular layer epitaxy or molecular beam epitaxy a first epitaxial layer having an impurity doping concentration lower than that of a substrate and forming on said first epitaxial growth layer a second epitaxial growth layer of conductivity type opposite to that of said substrate having an impurity doping concentration higher than that of said first epitaxial growth layer.

The thickness of said second epitaxial growth layer may be 50nm (500 Å) or less.

Preferably the thickness of said first epitaxial growth layer is the same as or greater than the depth of a depletion layer at a channel region.

The invention is illustrated, merely by way of example, in the accompanying drawings in which:-
Figure 1A is a schematic cross-section of a MOSFET according to the present invention in which a channel region comprises one type of epitaxial growth layer;
Figure 1B is a schematic cross-section of a MOSFET according to the present invention in which two epitaxial growth layers of different thickness, impurity concentration and opposite conductivity to each other are formed at a channel region;
Figure 2 shows threshold-dependence on epitaxial growth layer thickness of a MOSFET according to the present invention;
Figure 3 shows threshold-dependence on channel length of a MOSFET according to the present invention and a conventional MOSFET;
Figure 4 shows transconductance-dependence on threshold voltage of the MOSFETs shown in Figure 3;
Figures 5A to 5J illustrate a method according to the present invention of manufacturing a MOSFET in which a source region and a drain region are formed by ion implantation, and thereafter a channel region is formed by selective epitaxy;
Figure 6 illustrates a process according to the present invention for manufacturing a MOSFET having two different epitaxial growth layers; and
Figure 7 shows a vertical impurity doping profile of a channel region of the MOSFET shown in Figure 6.

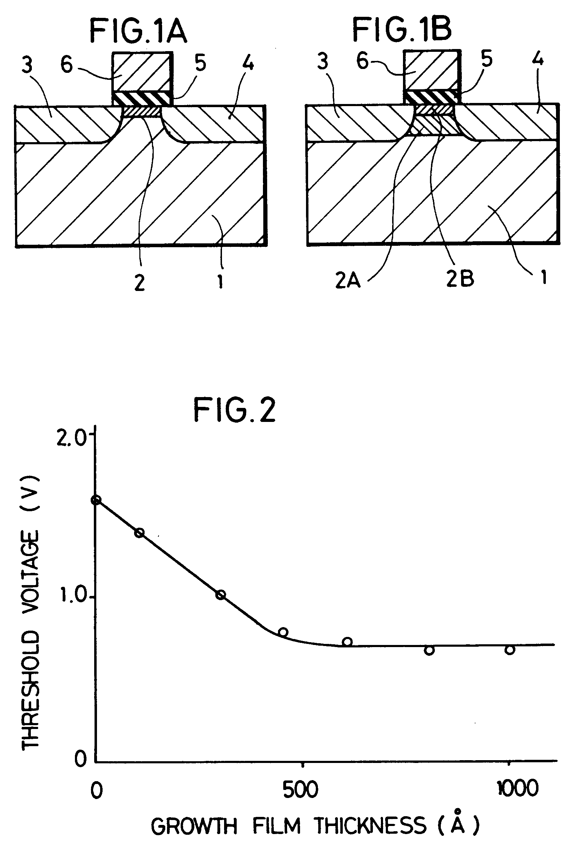

Figures 1A and 1B show two embodiments of MOSFETs according to the present invention.

Figure 1A shows a MOSFET in which an epitaxial growth layer 2 is formed on a substrate 1 of high impurity doping concentration. The epitaxial growth layer 2 has an impurity doping concentration lower than that of the substrate.

The MOSFET shown in Figure 1B has two epitaxial growth layers 2A,2B of different impurity doping concentration and different thickness provided on the substrate 1 of high impurity doping concentration. This structure provides a buried channel type device. The first epitaxial growth layer 2A has an impurity doping concentration lower than that of the substrate 1. The impurity of the second epitaxial growth layer 2B has a conductivity type opposite to that of the substrate and an impurity doping concentration higher than that of the first epitaxial layer 2A.

Figure 2 shows threshold-dependence on epitaxial growth layer thickness of the MOSFET shown in Figure 1A. In the case of Figure 2, the impurity doping concentration of the substrate 1 is 1 x 10¹⁷cm⁻³, that of the epitaxial growth layer 2 is 1 x 10¹⁴cm⁻³ and the gate length is 1 micron. It is shown from Figure 2 that the threshold voltage varies with the thickness of the epitaxial growth layer formed in a channel region. Thus it can be seen that for these values of impurity concentrations, the depletion layer forms with a thickness of approximately 50nm (500 Å), hence the reduced threshold voltage at that thickness.

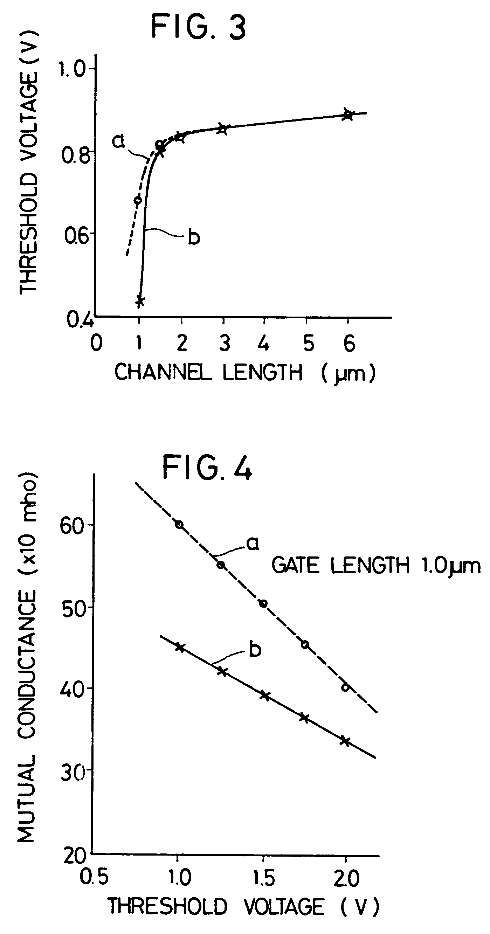

Figure 3 shows the threshold-dependence on channel length of a MOSFET according to the present invention and of a conventional MOSFET manufactured with a substrate of impurity doping concentration of 3 x 10¹⁶cm⁻³. The MOSFET according to the present invention shown in Figure 3, has, at its channel region, an epitaxial growth layer whose thickness is 30 nm (300 Å) and impurity doping concentration is 1 x 10¹⁴cm⁻³. This epitaxial growth layer is formed on a substrate having an impurity doping concentration of 1 x 10¹⁸cm⁻³. The epitaxial growth layer is formed through the use of molecular layer epitaxy or molecular beam epitaxy. Curve a shows the relationship between threshold-dependence on channel length of the MOSFET according to the present invention and shown in Figure 1A, and curve b shows the same for the conventional MOSFET. It is clearly seen from Figure 3 that the MOSFET according to the present invention is excellent in preventing short channel effects compared with the conventional MOSFET.

Figure 4 shows transionductance-dependence on threshold voltage of a MOSFET according to the present invention and shown in Figure 1A (line a) and a conventional MOSFET (line b). It is clearly observed from Figure 4 that a MOSFET according to the present invention has a carrier mobility more than 20% higher than that of a conventional MOSFET at a given threshold voltage.

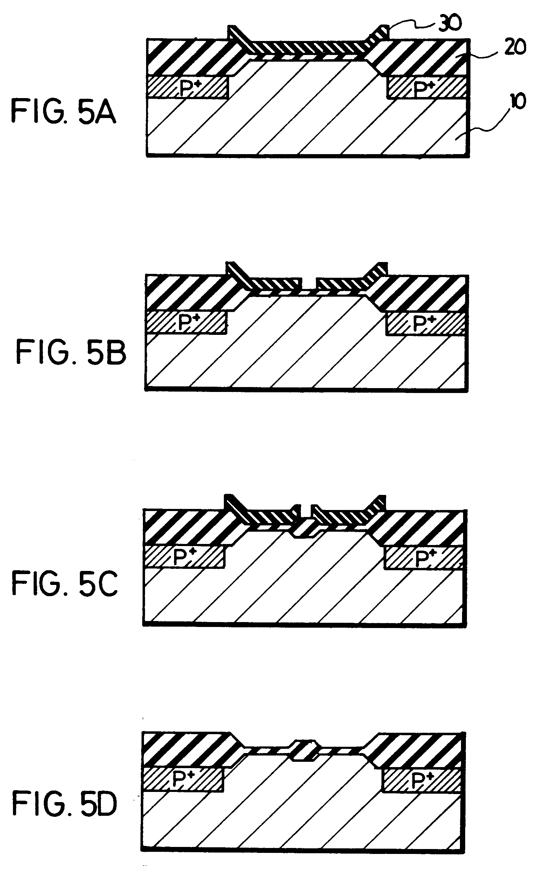

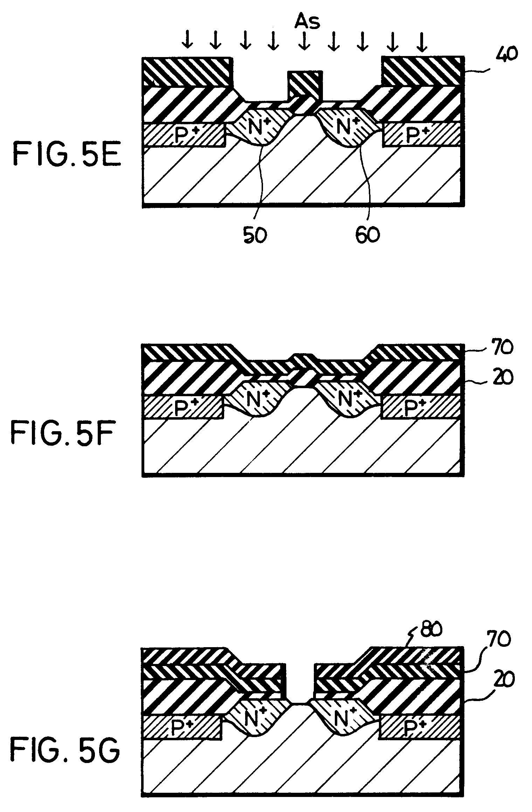

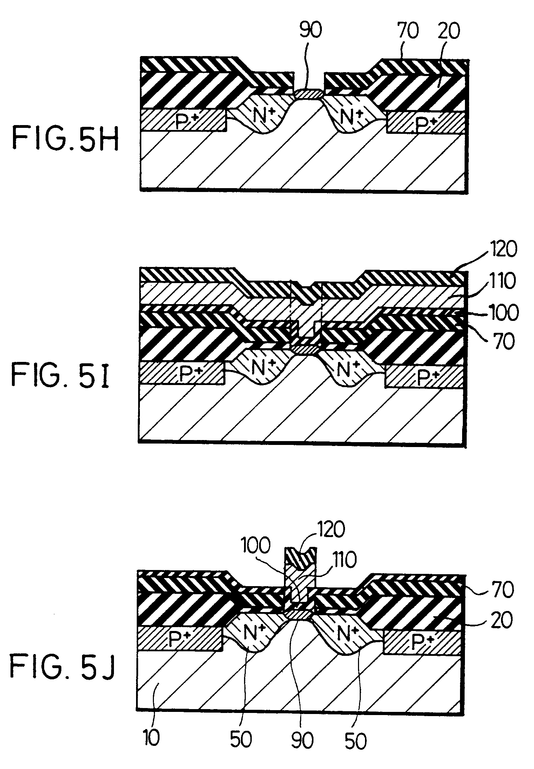

Figures 5A to 5G illustrate one method according to the present invention for manufacturing a MOSFET in which a source region and a drain region are formed by ion implantation prior to formation of a channel region. This MOSFET is characterized by a structure in which the channel region is partially curved down into the substrate surface. Figure 5A shows a cross-section of a conventional LOCOS (Local Oxidation of Silicon). A field oxide film 20 of about 600nm (6000 Å) thickness and a silicon nitride film 30 of about 300nm (3000 Å) thickness are formed on a substrate 10. The silicon nitride film on a channel forming region is partially etched away as shown in Figure 5B. Thermal oxidation is carried out to form a field oxide film of about 900nm (9000 Å) thickness and an oxide film of about 300nm (3000 Å) thickness at the channel forming region as shown in Figure 5C. Figure 5D shows a step in which the silicon nitride film 30 is removed. After a resist pattern 40 (Figure 5E) is formed, arsenic (As) is ion-implanted and annealing is carried out at about 900°C to form a source region 50 and a drain region 60. A chemical vapour deposition (CVD) oxide film 70 of about 300nm (3000 Å) is deposited as shown in Figure 5F. By using a photoresist, all the oxide films at the channel forming region are removed as shown in Figure 5G. Using the oxide film 70 as a mask, an epitaxial growth layer 90 is selectively deposited as shown in Figure 5H. The temperature of the substrate during this epitaxial growth is about 800°C and the epitaxial growth layer is grown to a thickness of about 1500 Å with an impurity doping concentration of about 1 x 10¹³cm⁻³. As shown in Figure 5I, a gate oxide film 100 of about 20nm (200 Å) thickness is formed by using a CVD technique at a substrate temperature of 700°C and thereafter an impurity doped polysilicon film 110 is deposited thereon at a substrate temperature of 750°C. All the polysilicon film 110 except for an area at the gate region is removed as shown in Figure 5J. The MOSFET manufactured in the manner described hereinabove can have a channel region completely free of damage by ion-implantation and without impurity auto-doping from the substrate 1.

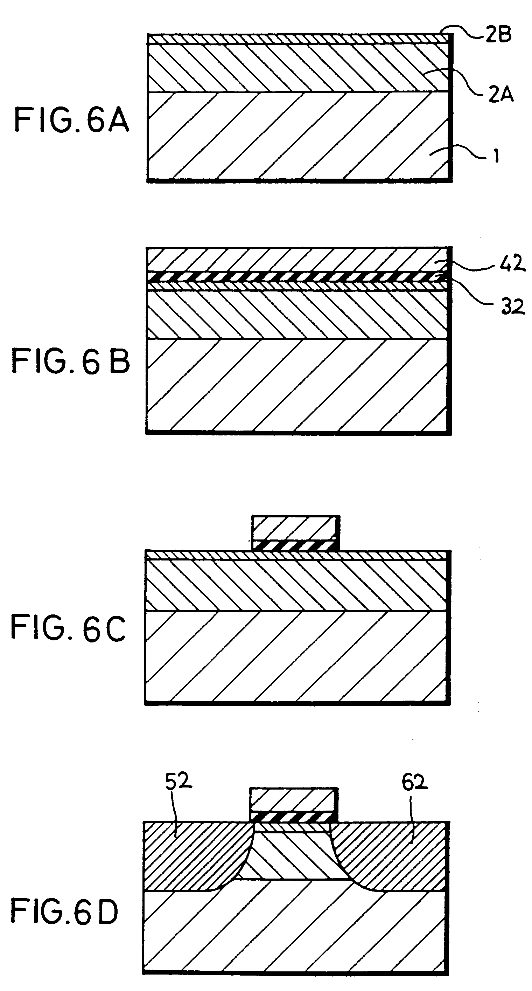

Figures 6A to 6D show a method according to the present invention of manufacturing a MOSFET having two epitaxial growth layers of different thickness and impurity concentration, the MOSFET being of the form shown in Figure 1B. Figure 6A shows a step in which the two epitaxial growth layers 2A,2B are formed on the substrate 1 of high impurity doping concentration while controlling impurity doping concentration of the layers. This employs molecular layer epitaxy which is carried out at a substrate temperature of 850°C or less. The impurity doping concentration of the substrate 1 is 1 x 10¹⁸cm⁻³. The first epitaxial growth layer 2A has an impurity doping concentration of 1 x 10¹³cm⁻³ and a thickness of 300nm (3000 Å). The second epitaxial growth layer 2B has an impurity doping concentration of 1 x 10¹⁶cm⁻³ and a thickness of 50nm (500 Å). A gate oxide film 32 and a polysilicon film for a gate 42 are deposited using a CVD technique as shown in Figure 6B. In Figure 6C the gate 42 is provided by patterning using a photoresist. A source region 52 and a drain region 62 are formed by ion-implantation using the gate as a mask as shown in Figure 6D.

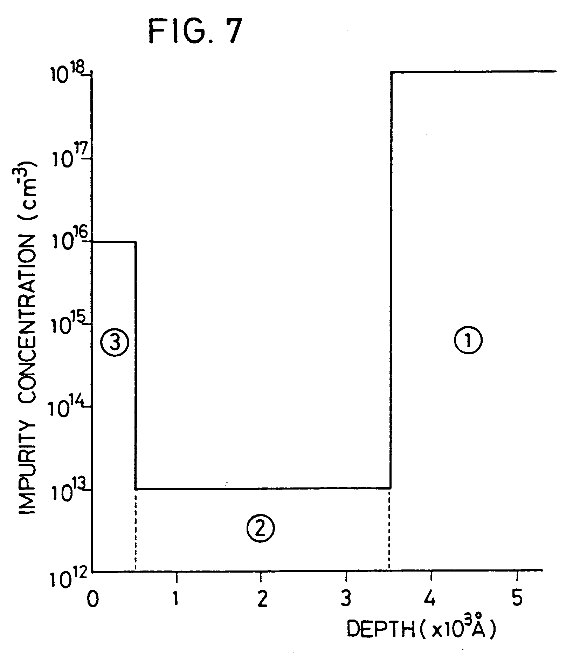

Figure 7 shows the vertical impurity doping profile at the channel region of the MOSFET of Figure 6. Numeral 1 in Figure 7 is the substrate of high impurity doping concentration, numeral 2 is the first epitaxial growth layer and numeral 3 is the second epitaxial growth layer.

A MOSFET according to the present invention has a structure in which the junction capacitance between the substrate and the source and drain regions is small, and short channel effects are prevented. MOSFETs fabricated according to the present invention are very effective in preventing latch-up and short channel effects. Moreover, a high performance in both static and dynamic characteristics which is not possible with conventional devices can be obtained. The present invention thus provides MOSFETs which have highly improved semiconductor device performance and which operate with high speed and low power consumption. This is achieved by providing an epitaxial growth layer or layers on a substrate of high impurity doping concentration, the thickness of the epitaxial growth layer(s) being controlled with a degree of accuracy of the order of a single atomic layer.

## Claims

1. A MOS field effect transistor comprising:
a semiconductor substrate (1) having an impurity concentration of at least 3 x 10¹⁶ cm⁻³ and a relatively short channel region disposed therein; characterised by
an epitaxial growth layer (2, 2B) provided in said channel region, having an impurity concentration lower than that of said substrate and a thickness of 50nm (500 Å) or less.

2. A MOS field effect transistor as claimed in claim 1, in which said epitaxial growth layer (2B) exists on at least one different kind of epitaxial growth layer (2A) having different impurity doping concentration and thickness.

3. A MOS field effect transistor as claimed in claim 2, in which there is an upper and a lower epitaxial growth layer and the upper epitaxial growth layer (2B) has a conductivity type opposite to that of the substrate (1).

4. A MOS field effect transistor as claimed in claim 2 or 3, in which there is an upper and a lower epitaxial growth layer and the upper epitaxial growth layer (2B) has an impurity concentration higher than that of the lower epitaxial growth layer (2A).

5. A method of manufacturing a MOS field effect transistor as claimed in claim 1 characterised by comprising: forming on a substrate (10) a source region (50) and a drain region (60) by using ion implantation, and thereafter selectively depositing an epitaxial growth layer (90) at a substrate temperature of 850°C or less between said source (50) and drain (60) regions to form a channel region.

6. A method as claimed in claim 5 characterised by forming the substrate (10) with a partially concave area such that said epitaxial growth layer (90) is selectively deposited on a portion of the substrate surface lower than other areas of the substrate surface.

7. A method as claimed in claim 5 or 6 characterised by finally forming a thermal oxide film (100) on the substrate surface forming a polysilicon film (110) thereover and thereafter etching said polysilicon film except over said channel region.

8. A method of manufacturing a MOS field effect transistor as claimed in any one of claims 1 to 4 characterised by comprising forming on a substrate (1) using molecular layer epitaxy or molecular beam epitaxy a first epitaxial layer (2A) having an impurity doping concentration lower than that of a substrate (1) and forming on said first epitaxial growth layer (2A) a second epitaxial growth layer (2B) of conductivity type opposite to that of said substrate having an impurity doping concentration higher than that of said first epitaxial growth layer.

9. A method as claimed in claim 8 characterised in that the thickness of said second epitaxial growth layer (2B) is 50nm (500 Å) or less.

10. A method as claimed in claim 8 or 9 characterised in that the thickness of said first epitaxial growth layer (2A) is the same as or greater than the depth of a depletion layer at a channel region.

## Patentansprüche

1. MOS-Feldeffekttransistor umfassend:
ein Halbleitersubstrat (1) mit einer Fremdstoffkonzentration von wenigstens 3 x 10¹⁶cm⁻³, und
einen darin angeordneten, relativ kurzen Kanalbereich, gekennzeichnet durch,
eine in dem Kanalbereich vorgesehene, epitaktisch gewachsene Schicht (2, 2B) mit einer Fremdstoffkonzentration, die kleiner ist als diejenige des Substrats, und einer Dicke von 50 nm (500 Å) oder weniger.

2. MOS-Feldefrekttransistor nach Anspruch 1, in welchem die epitaktisch gewachsene Schicht (2B) auf wenigstens einer anderen Art einer epitaktisch gewachsenen Schicht (2A) besteht, welche eine andere Fremdstoffdotierkonzentration und eine andere Dicke aufweist.

3. MOS-Feldeffekttransistor nach Anspruch 2, in welchem eine obere und eine untere epitaktisch gewachsene Schicht vorgesehen sind und die obere epitaktisch gewachsene Schicht (2B) einen dem Leitungstyp des Substrats (1) entgegengesetzten Leitungstyp aufweist.

4. MOS-Feldeffekttransistor nach Anspruch 2 oder 3, in welchem eine obere und eine untere epitaktisch gewachsene Schicht vorgesehen sind und die obere epitaktisch gewachsene Schicht (2B) eine höhere Fremdstoffkonzentration als die untere epitaktisch gewachsene Schicht (2A) aufweist.

5. Verfahren zum Herstellen eines MOS-Feldeffekttransistors gemäß Anspruch 1, dadurch gekennzeichnet, daß es umfaßt:
- das Bilden eines Source-Bereichs (50) und eines Drain-Bereichs (60) auf einem Substrat (10) durch Verwendung einer Ionenimplantation, und danach
- das selektive Ablagern einer epitaktischen Schicht (90) zwischen dem Source-Bereich (50) und dem Drain-Bereich (60) bei einer Substrattemperatur von 850°C oder weniger, um einen Kanalbereich zu bilden.

6. Verfahren nach Anspruch 5, gekennzeichnet durch das Ausbilden des Substrats (10) mit einem teilweise konkaven Bereich derart, daß die epitaktische Schicht (90) selektiv auf einem Abschnitt der Substratoberfläche abgelagert wird, der niederer ist als andere Bereiche der Substratoberfläche.

7. Verfahren nach Anspruch 5 oder 6, gekennzeichnet durch das abschließende Bilden einer Schicht (100) aus thermischem Oxid auf der Substratoberfläche, das Bilden einer Polysiliziumschicht (110) darüber und das darauffolgende Ätzen der Polysiliziumschicht (110) mit Ausnahme über dem Kanalbereich.

8. Verfahren zur Herstellung eines MOS-Feldeffekttransistors gemäß einem der Ansprüche 1 bis 4,
dadurch gekennzeichnet, daß es umfaßt:
- das Bilden einer ersten epitaktischen Schicht (2A) mit einer Fremdstoffdotierkonzentration, die kleiner ist als diejenige eines Substrats (1), auf dem Substrat (1) durch Verwendung einer Molekularschichtepitaxie oder einer Molekularstrahlepitaxie, und
- das Bilden einer zweiten epitaktisch gewachsenen Schicht (2B) mit einem dem Substrat entgegengesetzten Leitungstyp und einer Fremdstoffdotierkonzentration, die höher ist als diejenige der ersten epitaktisch gewachsenen Schicht, auf der ersten epitaktisch gewachsenen Schicht (2A).

9. Verfahren nach Anspruch 8, dadurch gekennzeichnet, daß die Dicke der zweiten epitaktisch gewachsenen Schicht (2B) 50 nm (500 Å) oder weniger ist.

10. Verfahren nach Anspruch 8 oder 9, dadurch gekennzeichnet, daß die Dicke der ersten epitaktisch gewachsenen Schicht (2A) größer oder gleich der Tiefe einer Verarmungsschicht an einem Kanalbereich ist.

## Revendications

1. Un transistor à effet de champ MOS comprenant :
un substrat semiconducteur (1) ayant une concentration en impureté d'au moins 3 x 10¹⁶ cm⁻³ et une région de canal relativement courte formée à l'intérieur; caractérisé par
une couche épitaxiale (2, 2B) formée dans la région de canal, ayant une concentration en impureté inférieure à celle du substrat et une épaisseur de 50 nm (500 Å) ou moins.

2. Un transistor à effet de champ MOS selon la revendication 1, dans lequel la couche épitaxiale (2B) est présente sur au moins une sorte différente de couche épitaxiale (2A) ayant une épaisseur et une concentration de dopage en impureté différentes.

3. Un transistor à effet de champ MOS selon la revendication 2, dans lequel il existe une couche épitaxiale supérieure et une couche épitaxiale inférieure, et la couche épitaxiale supérieure (2B) a un type de conductivité opposé à celui du substrat (1).

4. Un transistor à effet de champ MOS selon la revendication 2 ou 3, dans lequel il existe une couche épitaxiale supérieure et une couche épitaxiale inférieure, et la couche épitaxiale supérieure (2B) a une concentration en impureté supérieure à celle de la couche épitaxiale inférieure (2A).

5. Un procédé de fabrication d'un transistor à effet de champ MOS selon la revendication 1, caractérisé en ce qu'il comprend les étapes suivantes : on forme sur un substrat (10) une région de source (50) et une région de drain (60), en utilisant l'implantation ionique, et on dépose ensuite sélectivement une couche épitaxiale (90) à une température de substrat de 850°C ou moins entre les régions de source (50) et de drain (60), pour former une région de canal.

6. Un procédé selon la revendication 5, caractérisé en ce qu'on forme une région partiellement concave dans le substrat (10), de façon que la couche épitaxiale (90) soit déposée sélectivement sur une partie de la surface du substrat qui est à un niveau inférieur à celui d'autres régions de la surface du substrat.

7. Un procédé selon la revendication 5 ou 6, caractérisé en ce qu'on forme finalement une pellicule d'oxyde thermique (100) sur la surface du substrat, on forme une pellicule de silicium polycristallin (110) sur la pellicule d'oxyde thermique et on enlève ensuite par attaque la pellicule de silicium polycristallin sauf sur la région de canal.

8. Un procédé de fabrication d'un transistor à effet de champ MOS selon l'une quelconque des revendications 1 à 4, caractérisé en ce qu'on forme sur un substrat (1) en utilisant l'épitaxie par couches moléculaires ou l'épitaxie par jets moléculaires, une première couche épitaxiale (2A) ayant une concentration de dopage en impureté inférieure à celle d'un substrat (1), et on forme sur cette première couche épitaxiale (2A) une seconde couche épitaxiale (2B) ayant un type de conductivité opposé à celui du substrat et ayant une concentration de dopage en impureté supérieure à celle de la première couche épitaxiale.

9. Un procédé selon la revendication 8, caractérisé en ce que l'épaisseur de la seconde couche épitaxiale (2B) est de 50 nm (500 Å) ou moins.

10. Un procédé selon la revendication 8 ou 9, caractérisé en ce que l'épaisseur de la première couche épitaxiale (2A) est égale ou supérieure à la profondeur d'une couche de désertion dans une région de canal.
